(19) **Europäisches Patentamt / European Patent Office / Office européen des brevets**

(11) **EP 1 821 407 B1**

(12) **EUROPEAN PATENT SPECIFICATION**

(45) Date of publication and mention
of the grant of the patent:
**15.07.2009 Bulletin 2009/29**

(51) Int Cl.:
*H03H 17/04* (2006.01) *H04L 25/02* (2006.01)

(21) Application number: **06075405.8**

(22) Date of filing: **21.02.2006**

(54) **OFDM channel estimation systems**

System zur OFDM-Kanalschätzung

Système d'estimation de canal d'OFDM

(84) Designated Contracting States:
**AT BE BG CH CY CZ DE DK EE ES FI FR GB GR HU IE IS IT LI LT LU LV MC NL PL PT RO SE SI SK TR**

(43) Date of publication of application:
**22.08.2007 Bulletin 2007/34**

(73) Proprietor: **Frontier Silicon Limited**
**Dublin 8 (IE)**

(72) Inventor: **McNally, Conor**
**Dublin 8 (IE)**

(74) Representative: **Martin, Philip John**
**Marks & Clerk LLP**
**62-68 Hills Road**
**Cambridge**
**CB2 1LA (GB)**

(56) References cited:
**EP-A- 1 580 948          WO-A-99/60940**

- KIM C W ET AL: "Approximately linear phase IIR polyphase filter design" SPEECH PROCESSING 2, VLSI, UNDERWATER SIGNAL PROCESSING. TORONTO, MAY 14 - 17, 1991, INTERNATIONAL CONFERENCE ON ACOUSTICS, SPEECH & SIGNAL PROCESSING. ICASSP, NEW YORK, IEEE, US, vol. VOL. 2 CONF. 16, 14 April 1991 (1991-04-14), pages 1621-1624, XP010043211 ISBN: 0-7803-0003-3
- HUTTER A A ET AL: "Channel estimation for mobile OFDM systems" VEHICULAR TECHNOLOGY CONFERENCE, 1999. VTC 1999 - FALL. IEEE VTS 50TH AMSTERDAM, NETHERLANDS 19-22 SEPT. 1999, PISCATAWAY, NJ, USA,IEEE, US, vol. 1, 19 September 1999 (1999-09-19), pages 305-309, XP010352881 ISBN: 0-7803-5435-4

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

This invention generally relates to apparatus, methods and computer program code for interpolation using an Infinite Impulse Response (IIR) filter, in particular for OFDM (Orthogonal Frequency Division Multiplexing) channel estimation. The techniques described are particularly suitable for time interpolation systems for Digital Audio Broadcasting and/or Digital Video Broadcasting.

Two important applications of OFDM in wireless systems are DAB and DVB (in part because the guard band of OFDM symbols enables the use of a single frequency network without interference between adjacent transmitters. Background information on DAB can be found in, for example, the BUREKA-147 standard (ETSI Document EM300 401 V1.3.3 (2001-5); reference may also be made to BS EN 50248.2001. Background information relating to DVB can be found on the website www.dvb.org; there are several variants of the system including DVB-T (terrestrial) and DVB-H (handheld), all employing OFDM. In addition there is a corresponding standard in Japan; ISDB (Integrated Services Digital Broadcasting) and in the USA (Advanced Television Systems Committee - ATSC) as well as in some other countries for example Korea. By way of illustration, for further details of the DVB-H reference may be made to the ETSI standard EN302 304; further details of DVB-T can be found in a series of other ETSI standards, well known to those skilled in the art (see, for example, EN 300 744 which describes the DVB framing structure and pilot signals for the so-called 2K, 4K and 8K modes, in particular at sections 4.4 and 4.5). Although the details of the different systems vary they all employ OFDM.

Broadly speaking in an OFDM communications system data is carried on a set of substantially mutually orthogonal sub-carriers, which together comprise an OFDM symbol. Because multiple sub-carriers are employed the effective data rate on each sub-carrier is relatively low. Because the sub-carriers are orthogonal they can overlap in frequency and still be separated at the receiver - this is because, in effect, during an integration over the period of one sub-carrier, the other sub-carriers averaged zero.

To generate an OFDM symbol an inverse Fourier transform is performed on a set of input symbols, the sub-carriers are orthogonal if they are spaced apart in frequency by an interval of 1/T, where T is the OFDM symbol period. At the receiver the input symbols can be recovered by performing a Fourier transform. A range of sub-carrier modulation schemes may be employed, for example PAM (Pulse Amplitude Modulation) and PSK (Phase Shift Keying), but commonly, and in particular in DVB systems, QAM (Quadrature Amplitude Modulation) is employed. To reduce the effects of multipath OFDM symbols are normally extended by a guard period at the start or end of each symbol so that no ISI (Inter Symbol Interference) or ICI (Inter-Carrier Interference) will occur between signals with a difference in propagation time less than this guard period.

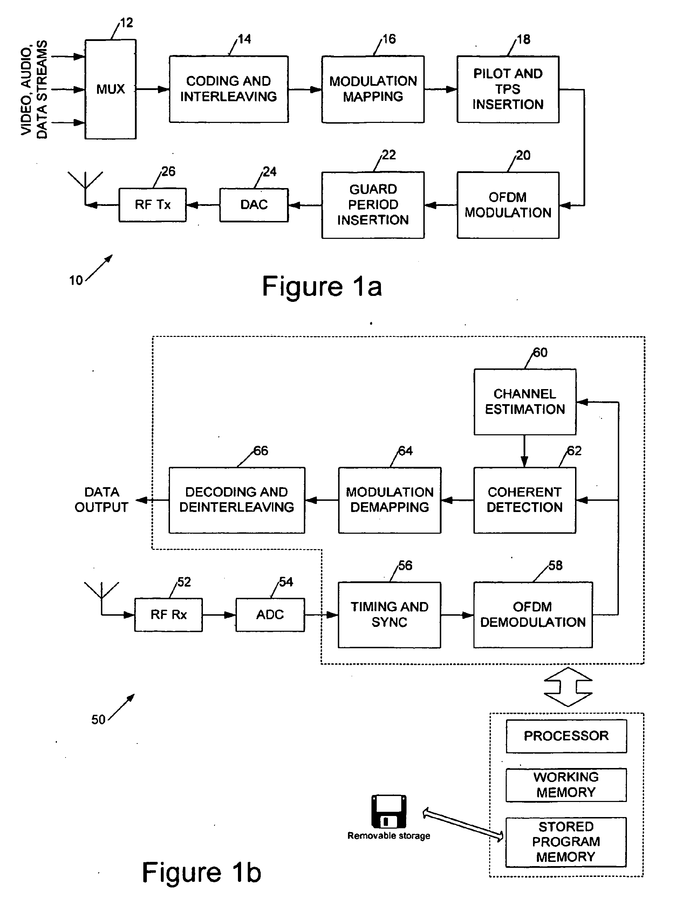

Figure 1a shows a simplified block diagram of a DVB-T transmitter 10. An initial multiplexer 12 receives video, audio and data streams which are combined and fed to a coding and interleaving stage 14 which performs outer Reed-Solomon coding and interleaving and inner convolutional coding and interleaving. Modulation mapping 16 is then performed, onto either QPSK, 16-QAM or 6-QAM symbols. The pilot tones and TPS (Transmission Parameter Signalling) data (which specifies parameters such as modulation type, guard interval and inner code rates) are then inserted 18 and OFDM modulation 20 is then performed, typically by serial-2-parallel conversion, an Inverse Fast Fourier Transform (IFFT) and subsequent parallel-2-serial conversion. The guard period is then inserted 22 by adding a cyclic prefix to the OFDM symbol and the signal is passed to a digital-2 analogue converter 24, which provides an analogue output to an RF transmitter 26.

Figure 1b shows a simplified block diagram of a DVB receiver 50. This mirrors the transmitter and comprises an RF front end 52 which provides an analogue signal to an analogue-2 digital converter 54, which in turn provides an output to a timing and synchronisation stage 56, which also removes the cyclic prefix. OFDM demodulation 58 is then performed, generally by a serial-2 parallel conversion followed by a Fast Fourier Transform (FFT) and a parallel-2-serial conversion. The output of the OFDM demodulation stage is provided to a channel estimation block 60 which provides channel estimate data to a coherent detection stage 62. This compensates the constellation of each sub-carrier for the phase and amplitude variation introduced by the channel. Modulation demapping 54 is then performed, followed by decoding and deinterleaving 66, which mirrors the coding and interleaving at the transmitter, to provide a data output. The elements enclosed by the dashed line may be implemented in hardware, in software on a digital signal processor (as shown by the inset diagram), or in a combination of the two.

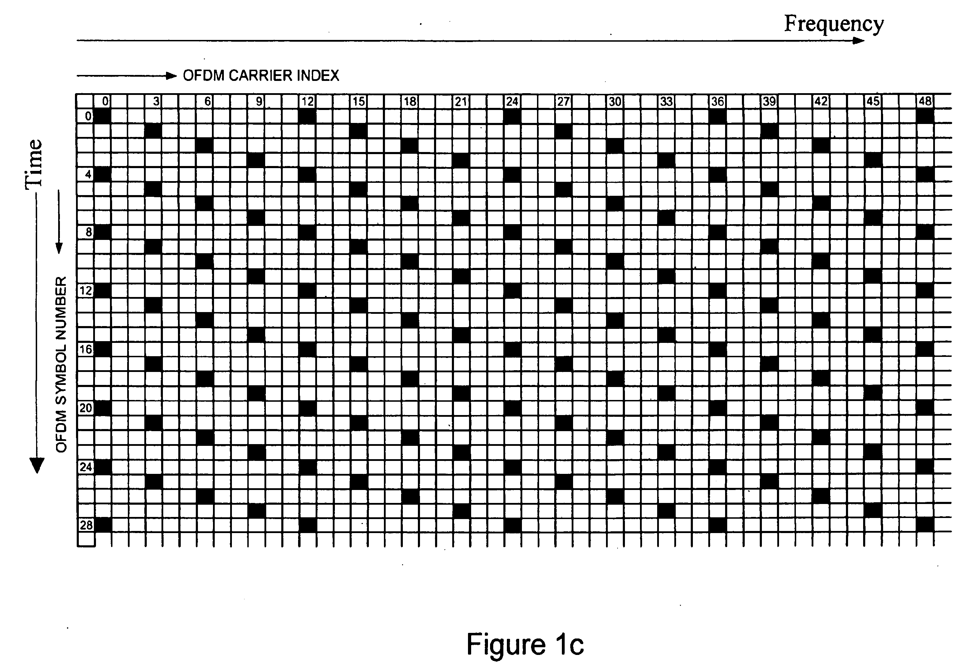

A DVB-T system has two main modes referred to as the 2K and 8K modes, using 1705 and 6817 sub-carriers respectively. In the 8K mode there are 768 pilots in each OFDM symbol (leaving 6048 sub-carriers for data); in the 2K mode there are 192 pilots (leaving 1512 sub-carriers for data). The position of the pilots is different from one symbol to the next, with a pattern which repeats after 4 OFDM symbols. Figure 1c illustrates the scattered pilot structure of DVB-T/H. The pilot tones allow the channel estimation block 60 of Figure 1b to estimate a channel value (amplitude and phase) for each sub-carrier. The pilots are distributed to allow the channel estimation block to estimate across both frequency and time. (In a packet-based system time estimation may be omitted on the assumption that the channel does not change significantly over a packet interval). In mobile systems, in particular time varying fading can be important as the channel conditions can change rapidly. It can be seen by inspection of the pilot structure of Figure 1c that across-frequency and across-time interpolation is needed.

As previously mentioned, in pilot aided OFDM, pilot (known) values are inserted into the transmitted OFDM symbols at known locations to estimate and remove the effects of the Channel from the received symbol. The received symbol can be expressed as:

$$Y = XH + N$$

Where X is a vector containing the Transmitted symbol, H is the channel vector and N is the received noise vector.

Channel estimates at the pilot locations can be calculated from

$$\tilde{H}(k) \doteq \frac{Y(k)}{X(k)} \doteq H(k) + \frac{N(k)}{X(k)}$$

where, k = pilot (sub)carrier index and X(k) = pilot values.

In order to find an estimate for the complete channel vector we can interpolate between the estimated channel values at the pilot positions. Depending on the pilot structure we can use either time interpolation or frequency interpolation or a combination of both.

We first describe frequency interpolation.

Referring again to Figure 1c, which illustrates the pilot structure used in DVB-T/H, it can be seen that on each OFDM symbol every 12th carrier is a pilot value. Therefore we can calculate channel estimates on every 12th carrier. To estimate the channel across the entire symbol we can simply frequency interpolate between the channel estimates at pilot locations.

However only 1 in 12 carriers is a pilot therefore the frequency resolution provided by the pilots is 12 times the Carrier spacing. Frequency interpolation is also constrained by sampling theorem and therefore can only track channels with a delay spread less than Tu/12, where (time) Tu is the inverse of the carrier spacing.

We next describe time interpolation.

In the DVB-T/H example of Figure 1c, in the time direction pilots are repeated in the same (sub)carrier position every four symbols, for example a Pilot exists on carrier 0 of Symbol 0 and Symbol 4. Therefore, for example, time Interpolation between Symbol 0 and Symbol 4 can be used to estimate channel values on Carrier 0 of symbols 1, 2 and 3. Similarly time interpolation can be used to estimate a Channel value on every 3rd carrier of the OFDM symbol (because, over time, there are pilots on every third carrier).

We now describe time and frequency interpolation.

For DVB-T/H time interpolation provides chan-

nel estimates on every 3rd carrier of an OFDM symbol, and this provides enough frequency resolution to track a channel, with a delay spread up to Tu/3 (rather than Tu/12), with frequency interpolation.

We now describe Maximum Doppler Frequency.

Time interpolation also has restrictions. In the time direction the pilots sample the channel at a sample rate that is calculated from the distance between pilots:

$$SR = \frac{1}{N_t T_s (1 + GI)}$$

where Nt is the distance between pilots in the time direction (in terms of number of OFDM symbols), Ts is the Symbol Time, and GI is the Guard interval. In the example of Figure 1c, Nt = 4, and if we are in, say, the DVB 8K mode (Ts = 8192x1.09e$^{-7}$ = 8.96e$^{-4}$ seconds) with a Guard interval of 1/4, then SR = 223Hz.

With this sample rate the maximum Doppler frequency (MDF) that can be tracked with time interpolation is 111.5Hz (i.e. the Nyquist frequency). However Channels with delay spreads of up to Tu/3 can be tracked. To track channels with higher Doppler frequency, frequency interpolation only can be used (ie. without waiting for successive pilots every fourth OFDM symbol), but the channel estimation will then only be accurate for delay spreads <Tu/12.

An ideal time interpolation filter would have a brick wall response with unity gain up to max Doppler frequency. However with memory and complexity constraints in the receiver it is difficult to implement even a near optimal filter.

We next explain why time interpolation in particular provides significant challenges (although the techniques we describe later, to address these, are not limited to time interpolation).

For the DVB example discussed above time interpolation by a factor of 4 is requited. This can be achieved by zero-stuffing between the pilot input samples to provide an additional sample for each interpolated value required, and then by filtering using an FIR (finite impulse response) filter, which performs the interpolation.

To achieve a sub-optimal filter with unity gain up to 0.8 x MDF (Maximum Doppler Frequency) and 40dB rejection at 1.2 x MDF requires a 44 tap FIR filter. Due to the zero stuffing used in the interpolation the complexity of the filter can be reduced by the interpolation factor, that is, 11 taps executed per interpolated carrier and pilots from 11 symbols are stored in memory. However because the delay through the filter is 23, 23 symbols (half the length of the filter) must be buffered in a delay line before the effect of the channel can be removed.

When operating in 8K mode in DVB (6048 data carriers, 768 pilots) the storage requirements for an OFDM symbol, the memory requirements of the Time Interpolation, filter become quiet significant. For the 2k and 4k modes the memory requirements are less significant as smaller symbols are stored - for example, the memory storage requirements of twelve 4k-symbols and of six 8k-symbols are essentially the same. Also because 2k and 4k modes achieve much higher Doppler performance, sacrificing some bandwidth with a shorter filter is not such a big problem. Nonetheless the techniques we describe can still provide some advantage in 2k and 4k modes.

Optimizations in filter design using least squares have been described in A.A. Hutter, R. Hasholzner, J.S. Hammerschmidt, "Channel Estimation for Mobile OFDM Systems", Institute for Integrated Circuits BRIDGELAB Digital Signal Processing, Technical University of Munich (http://www.lis.ei.tum.de/research/lm/papers/vto99b.pdf). These sacrifice passband ripple for a steep roll-off to the stopband, and an 8-pilot (32-Tap filter) is proposed to achieve good Doppler performance. However even with these optimizations memory requirements are still large. Further background prior art can be found in WO03/065609 and in JP2004/104744.

We now describe some problems with using an IIR (infinite impulse response) Time Interpolation filter.

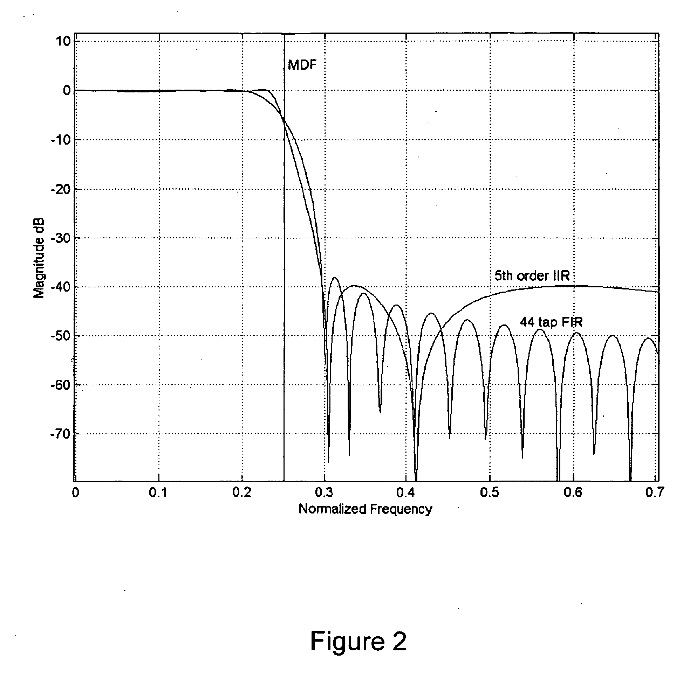

Referring to Figure 2, this shows a comparison of magnitude responses of a 44-Tap FIR filter and a fifth order IIR filter and it can be seen that a $5^{th}$ order IIR filter can achieve a similar magnitude response to the 44-tap FIR filter. The delay through the $5^{th}$ order IIR filter is 5 and therefore the filter would reduce the time interpolation memory requirements significantly. However the IIR filter performs very poorly because the time interpolation works best with a substantially linear phase response and a constant group delay, whereas an IIR filter has a strongly frequency-dependent group delay.

One method of achieving a linear phase response with an IIR filter would be to add additional equalizing coefficients to force a near linear phase response. However this would increase the filter order to a much higher order filter removing the memory benefits of using the IIR in the first place.

WO 9960940 discloses a digital interpolation filter comprising an infinite impulse response (IIR) filter and employing a forward-backward filtering methodology. In order to achieve a linear phase response the input sequence, upsampled and filtered by a first IIR filter stage, is time reversed, passed through a second IIR filter stage having the same transfer function as the first IIR filter stage and time reversed again.

In summary, in pilot-based OFDM channel estimates are calculated by time and frequency interpolation across channel values obtained from pilots inserted in the transmitted OFDM symbols. In the time direction the number of OFDM symbols that are buffered / stored before the effect of the channel is removed is equal to the delay through the time interpolation filter. The use of FIR filtering for time interpolation requires large memory buffers to delay the OFDM symbols appropriately before removing the effect of the channel. Infinite Impulse Response (IIR) interpolation filtering reduces the time delay and memory requirements but performs poorly due to its non-linear phase response. We will therefore describe techniques which address the phase response problems associated with IIR filters, although embodiments of these techniques are not restricted in their applicability to IIR filters but may, in general, be applied to any filter structure which would benefit from an improved, more linear phase response.

According to the present invention there is therefore provided a digital filter, the filter comprising: an input to receive complex-valued input samples; an up-sampler coupled to said input to provide an up-sampled output comprising an increased number of said input samples; a filter, in particular an Infinite Impulse Response (IIR) filter, coupled to said up-sampler to filter said up-sampled output and provide a filtered output; a phase rotation estimator coupled to said input and to said filtered output to estimate a phase rotation of a said input sample by said IIR filter; and a phase compensator coupled to said filtered output and to said phase rotation estimator to compensate said filtered output for said estimated phase rotation by said IIR filter and provide a phase compensated filter output.

The estimated phase rotation may comprise a rotation due to group delay through the filter although other phase distortions may also be taken into account. In embodiments the phase rotation estimator may comprise a divider to divide an input sample to the filter by a corresponding filtered output sample, which directly gives the phase delay. Where the filtered data comprises real-time data a delay may be incorporated to align corresponding input and filtered data.

Where the filtered data is noisy the output of the divider may be limited so that values greater than and/or less than a predetermined maximum or minimum are set to this maximum or minimum value. Optionally the phase compensated output of the filter may be smoothed to smooth any inaccuracies in the phase correction.

In preferred embodiments the filter is configured as an interpolation filter. In this case intermediate samples are introduced between the input samples for interpolation, for example by zero stuffing or a sample-and-hold module (to duplicate the input samples). The expanded (up-sampled) set of input samples is then filtered, the filtering in effect automatically interpolating between the input samples.

Preferably an interpolation filter includes a phase rotation interpolator to generate interpolated phase rotation estimates. To derive the interpolated phase rotation estimates a phase rotation interpolator may be employed to interpolate between the phase rotation estimates derived from the input samples prior to up-sampling. Where time interpolation is employed, depending upon the configuration it may be necessary to delay the filter output prior to applying the phase correction - for example if time interpolation is employed to interpolate between every fourth OFDM symbol then, in embodiments, a delay of four OFDM symbols may be needed. However in other embodiments, as described further below, no such time delay is needed.

The filter comprises an Infinite Impulse Response (IIR) filter, although the techniques described above may be applied to any filter with a non-linear phase response or group delay, for example a complex FIR (finite impulse response) filter or a skewed group delay FIR filter, or the like. In general embodiments the technique will work with any filter structure which requires phase correction.

We also describe an OFDM channel estimator including a filter as described above for interpolating between OFDM channel estimates. It will be appreciated that when interpolating between OFDM channel estimates the input to the filter may comprise a series of channel estimates or, for example, a series of pilot tones which are interpolated and then converted to channel estimates. Depending upon the implementation the filter is an IIR filter, but the above-described techniques may be applied to other types of filter.

Such an OFDM channel estimator includes a plurality of filters as described above, preferably one filter being allocated to each sub-carrier on which a pilot signal is present at any one time/symbol. In the DVB-T/H example given above at any one time a pilot is present on every twelfth sub-carrier and thus a filter is allocated to every twelfth sub-carrier; in the more general case to every, $n$th sub-carrier where every $n$th sub-carrier at any one time carries a pilot. In such an embodiment the phase rotation interpolator may be configured to interpolate across frequencies, that is to provide one or more interpolated phase rotation estimates for one or more sub-carriers intermediate between those bearing a pilot (and processed by a filter). Thus preferably one interpolation filter is provided for each sub-carrier on which a pilot appears (at any time), so that the interpolated phase correction derived from the sub-carriers on which pilots are present may be used to correct the filter phase for the other sub-carriers which are, at that instant, being time-interpolated. Thus, for example, using the above-mentioned case at symbol 0 pilots are present on carriers 0 and 12 and the across-frequency interpolated phase corrections from these sub-carriers may be applied to the filters performing the time interpolations on sub-carriers 3, 6 and 9. Broadly speaking this works because the sub-carriers do not differ greatly in frequency and because the phase correction (which is related to the group delay of the interpolation filter) does not vary much over the bandwidth of the filter.

We also describe an OFDM channel estimator, which is not a subject of the present invention, comprising: an input to receive complex-valued channel estimation data items; an up sampler coupled to said input to generate intermediate data items between said channel estimation data items; a digital filter coupled to said up sampler to filter said channel estimation data items and said intermediate data items to generate interpolated channel estimation data items; and a phase compensation system to adjust a phase of said channel estimation data items to compensate for said filter.

Preferably the channel estimator has a plurality of filters for time interpolation of channel estimation data items of a corresponding plurality of subcarriers of the processed OFDM signal. Further, as described above, preferably the estimator includes means for interpolating between phases compensating some of these filters to generate phase correction values for others of the filters. The skilled person will appreciate that references here to interpolation include extrapolation (which is essentially equivalent).

We also describe an OFDM receiver including an OFDM channel estimator as described above.

In a related aspect the invention provides a method of time domain interpolation in an OFDM channel estimator using an OFDM signal having a plurality of subcarriers, said sub-carriers bearing a structure of pilot signals in which at least first and second sub-carriers carry a pilot signal at corresponding first times, and in which a third subcarrier carries a pilot signal at second times different to said first time, the method comprising: interpolating between said first times for said first and second sub-carriers by filtering; determining respective first and second estimated phase rotations for said first and second subcarrier interpolating; compensating said interpolating for said first and second sub-carriers using said first and second estimated phase rotations; interpolating between said second times for said third subcarrier by filtering; and compensating for a phase rotation of filtering of said third subcarrier using an estimated phase rotation derived from one or both said first and second estimated phase rotations.

We also describe an OFDM channel estimator comprising means for implementing the above-described method.

We also describe a method of interpolation between complex-valued data items using a digital filter, the method comprising: receiving said complex-valued data items; up-sampling said data items to generate up-sampled data including intermediate data items; filtering said up-sampled data using a digital filter to generate filtered data including interpolated data items; and adjusting a phase of said filtered data to compensate for said filtering.

We also describe a filter comprising means for implementing the above-described method.

We also describe processor control code to implement the above-described methods, in particular on a data carrier such as a disk, CD- or DVD-ROM, programmed memory such as read-only memory (Firmware), or on a data carrier such as an optical or electrical signal carrier. Code (and/or data) to implement embodiments of the invention may comprise source, object or executable code in a conventional programming language (interpreted or compiled) such as C, or assembly code, code for setting up or controlling an ASIC (Application Specific Integrated Circuit) or FPGA (Field Programmable Gate Array), or code for a hardware description language such as Verilog (Trade Mark) or VHDL (Very high speed integrated circuit Hardware Description Language). As the skilled person will appreciate such code and/or data may be distributed between a plurality of coupled components in communication with one another.

These and other aspects of the invention will now be further described by way of example only, with reference to the accompanying figures in which:

Figures 1 a to 1c show, respectively, a block diagram of a DVB-T transmitter, a block diagram of a DVB receiver, and the scattered pilot structure of DVB-T/H;

Figure 2 shows a comparison of magnitude responses of a 44-Tap FIR filter and a fifth order IIR filter;

Figure 3 shows a block diagram of an IIR interpolation filter according to a first embodiment of the invention, incorporating a system for phase correction of the IIR interpolated complex-valued signals; and

Figures 4a and 4b shows block diagrams of an IIR time interpolation filter according to a second embodiment of the invention, incorporating a system for phase correction of the IIR interpolation in a scattered pilot OFDM channel estimator.

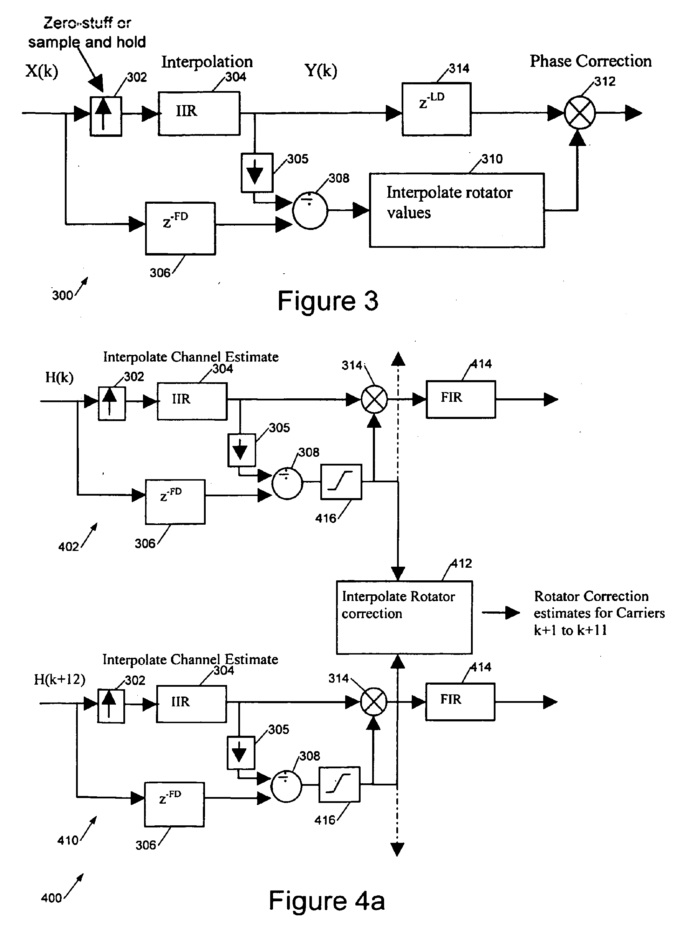

Referring to Figure 3, we first describe a system 300 for phase correction of IIR interpolated complex signals.

In Figure 3 the input X(k) is a complex signal which may represent, for example, an OFDM pilot value or channel estimate (it is, in the general case, a different variable to the pilot value X(k) mentioned in the introduction). The input X(k) is up sampled by an up-sampler 302, for example by zero stuffing (adding additional zeros between sample values), or by sample and hold (duplicating sample values), or by some other method known to those skilled in the art. The up sampled signal is then filtered (interpolated) with an IIR filter 304.

The rotation due to group delay is measured by dividing the original complex input X(k) by the output of the filter Y(k) using a divider 308. The input X(k) is delayed in a delay 306 by an amount equal to the average passband delay through the filter, *FD*, and the output of IIR filter 304 is down sampled by down-sampler 305 so that a ratio is obtained of corresponding input and output samples. This gives phase rotation estimates at the input sample rate.

To estimate rotation values across the interpolated values (i.e. at the up sampled rate) an interpolator 310 is employed to interpolation across the initial rotation values. The change in rotation values from sample to sample is dependent on the group delay response of the IIR filter, across the pass band, and on how close the initial sample rate of X(k) is to the Nyquist frequency. However from simulation it has been determined that simple linear interpolation of the phase rotation values provides accurate results in most cases.

The interpolated complex signal Y(k) is then phase corrected with the interpolated complex rotation estimates, by multiplying Y(k) by the phase correction in multiplier 312. In the Figure 3 system Y(k) is delayed, in delay 314, by an amount equal to the delay caused by the interpolation of the rotation values, *LD* (phase interpolation uses two phases, one determined later in time than the other). In some preferred embodiments the phase interpolation is substantially linear, although any interpolation technique can be employed.

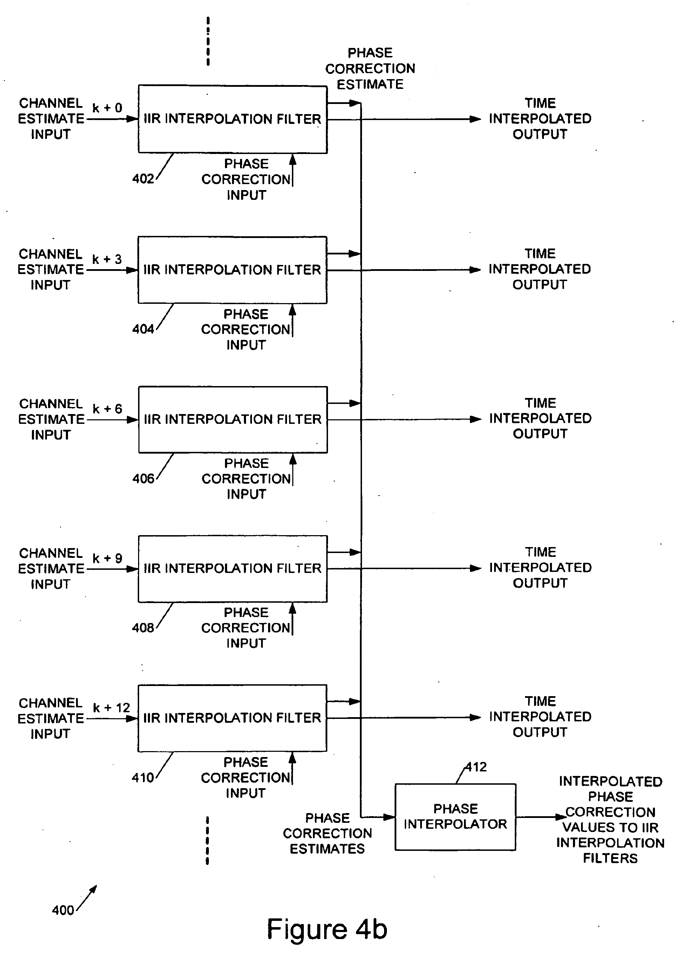

We now refer to Figures 4a and 4b to describe a system 400 for phase correction of IIR interpolated channel estimates in pilot-based OFDM.

In channel estimation in OFDM communication systems the pilot structure enables the added benefit that interpolation of the rotation values can be applied in the frequency direction thereby removing the delay caused in the rotation interpolation (delay LD in Figure 3).

An outline block diagram of the technique is illustrated in Figure 4b, for the example OFDM pilot structure shown in Figure 1c. Broadly speaking, for OFDM symbol 0 and, say, k = 0, IIR interpolation filters 402 and 410 are able to determine channel estimates and phase corrections. These phase corrections are across-frequency interpolated by interpolator 412 and applied to IIR interpolation filters 404, 406, 408, which are time interpolating as carriers k + 3, k + 6, and k + 9 do not carry pilot tones at OFDM symbol 0. At OFDM symbol 1 IIR interpolation filters for k + 3 (filter 404) and k + 15 (not shown) provide phase correction estimates, which are interpolated and provided to the intermediate IIR interpolation filters 406, 408, 410, and so forth.

Figure 4b shows a more detailed block diagram of the system, in which like elements to those of Figure 3 are indicated by like reference numerals. The channel estimates, which have been calculated directly from the pilots, are interpolated with an IIR filter 304. The complex output of the IIR filter is then rotated 312 to correct the non-linear phase response (varying delay) of the filter. The rotation values have been calculated for intermediate carriers by interpolation 412 in the frequency direction, for example for every third carrier for the example of Figure 1c. Note that the inputs to the phase rotators 312 changes from one OFDM symbol to the next.

Preferably, as a final step, the interpolated and phase corrected estimates are filtered with a simple 3-tap FIR filter 414 to smooth any residual inaccuracies in the phase correction.

As previously the Rotation values are calculated by dividing the initial Pilot Channel estimate by the output of the IIR (the interpolated Channel estimate). The accuracy of the rotation values is dependent on the accuracy of the channel estimates at the pilot locations - for example if a pilot is located in a deep null in the channel response it will be subject to AWGN (additive white Gaussian noise) and ICI noise and can therefore give an inaccurate rotation value. To limit the effect of inaccurate pilot/rotation values (which will become more apparent for channels with high Doppler frequencies and with long delay spreads) the rotation estimates can be limited/saturated to within a predetermined range by a limiter 416. Thus if the phase correction falls outside a predetermined range, which can be determined for example from the group delay response of the IIR filter, a fixed correction can be applied.

To estimate rotation values at non-pilot positions interpolation is used. Interpolation in either the time direction (Figure 3) or in the frequency direction (Figure 4) can be used. Interpolation in the frequency direction (Figure 4) has the advantage that no extra system delay is incurred due to the rotator interpolation thereby reducing memory requirements.

The accuracy of the rotation interpolation is dependent on the group delay response of the IIR filter. If the variation in group delay, is limited to a small number of samples, across the passband then simple linear interpolation can be used to estimate rotation values at non-pilot locations.

The system illustrated in Figure 4 is easily applied to DVB. For DVB a scattered pilot exists on every $12^{th}$ carrier. Therefore a rotation correction value is calculated on every $12^{th}$ carrier and the rotation values for the data carriers between the pilots are calculated with linear interpolation.

In a channel estimator for DVB the continual pilots can additionally or alternatively be utilised in estimating and interpolating rotation values.

As previously mentioned, to reduce distortions caused by inaccurate rotation values an FIR filter is preferably used to smooth the phase corrected estimates.

Referring again to Figure 1b, a system as described above may be used to implement channel estimation module 60, in either dedicated hardware, in software on a DSP (digital signal processor, as shown by the inset diagram), or in a combination of the two. The DSP control code may be provided on a carrier, illustratively shown by a disk.

From simulation of the system with a $5^{th}$ order IIR filter (and 3-tap FIR smoothing filter) the scheme provides similar or better channel estimation performance to a 6-pilot (24tap) FIR filter. The IIR scheme requires a delay of 6 symbols, whereas the 24-tap FIR requires a delay of 12 symbols. The IIR scheme will incur some additional processing overhead however the memory savings are significant. For example the skilled person will appreciate that for 8k symbols the scheme enables a substantial reduction in memory.

We have described a technique to autonomously correct the phase response of an IIR interpolated complex signal. The technique can be extended to IIR time interpolation for channel estimation in OFDM systems. The approach significantly reduces the memory requirements for time-interpolation while maintaining an equivalent performance to large FIR interpolation filters.

No doubt many other effective alternatives will occur to the skilled person. It will be understood that the invention is not limited to the described embodiments and encompasses modifications apparent to those skilled in the art lying within the scope of the claims appended hereto.

**Claims**

1. A digital filter (300), the filter comprising:

   an input to receive complex-valued input samples;
   an up-sampler (302) coupled to said input to provide an up-sampled output comprising an increased number of said input samples;
   an Infinite Impulse Response (IIR) filter (304) coupled to said up-sampler to filter said up-sampled output and provide a filtered output;
   a phase rotation estimator (308) coupled to said input and to said filtered output to estimate a phase rotation of a said input sample by said filter; and
   a phase compensator (312) coupled to said filtered output and to said phase rotation estimator to compensate said filtered output for said estimated phase rotation by said IIR filter and provide a phase compensated filter output.

2. A filter as claimed in claim 1 wherein said phase rotation estimator (308) comprises a divider to determine a ratio between a said input sample and a corresponding filtered output sample.

3. A filter as claimed in claim 1 or 2 wherein said phase rotation estimator (308) further comprises a limiter to limit a range of a said estimated phase rotation.

4. A filter as claimed in any preceding claim further comprising a smoothing filter coupled to said phase compensated filter output to provide a smoothed output.

5. An interpolation filter comprising a filter as claimed in any of claims 1 to 4 for interpolating between values of said input samples, the interpolation filter further comprising a phase rotation interpolator to interpolate between two of said phase rotation estimates and provide interpolated phase rotation estimates for compensating for phase rotations of said interpolated input sample values.

**6.** An OFDM channel estimator including the filter of any one of claims 1 to 5, said filter being configured to interpolate between OFDM channel estimates.

**7.** An OFDM channel estimator including a plurality of filters as claimed in any one of claims 1 to 4 each said filter being configured for time domain interpolation of between channel estimates for an OFDM subcarrier.

**8.** An OFDM channel estimator as claimed in claim 7 further comprising at least one phase rotation interpolation to interpolate between phase rotation estimates from two said filters for two of said OFDM sub-carriers and provide an interpolated phase rotation estimate to a phase compensator of a time domain interpolation filter for a third said OFDM subcarrier.

**9.** A method of time domain interpolation in an OFDM channel estimator using an OFDM signal having a plurality of sub-carriers, said sub-carriers bearing a structure of pilot signals in which at least first and second sub-carriers carry a pilot signal at corresponding first times, and in which a third subcarrier carries a pilot signal at second times different to said first time, the method comprising:

interpolating between said first times for said first and second sub-carriers by filtering;
determining respective first and second estimated phase rotations for said first and second sub-carrier interpolating;
compensating said interpolating for said first and second sub-carriers using said first and second estimated phase rotations;
interpolating between said second times for said third subcarrier by filtering; and
compensating for a phase rotation of filtering of said third subcarrier using an estimated phase rotation derived from one or both said first and second estimated phase rotations.

**Patentansprüche**

**1.** Digitalfilter (300), wobei das Filter umfasst:

einen Eingang zum Empfangen von komplexwertigen Eingangssamples;
einen Aufwärtssampler (302), der an den Eingang angeschlossen ist, um einen aufwärts gesampelten Ausgang bereitzustellen, der eine erhöhte Anzahl der Eingangssamples umfasst;
ein Filter mit endlicher Impulsantwort (IIR-Filter) (304), das an den Aufwärtssampler gekoppelt ist, um den aufwärts gesampelten Ausgang zu filtern und einen gefilterten Ausgang bereitzustellen;

einen Phasenrotationsschätzer (308), der an den Eingang und den gefilterten Ausgang gekoppelt ist, um eine Phasenrotation eines Eingangssamples durch das Filter zu schätzen; und
einen Phasenkompensator (312), der an den gefilterten Ausgang und den Phasenrotationsschätzer gekoppelt ist, um den gefilterten Ausgang für die geschätzte Phasenrotation durch das IIR-Filter zu kompensieren und einen phasenkompensierten Filterausgang bereitzustellen.

**2.** Filter nach Anspruch 1, worin der Phasenrotationsschätzer (308) einen Dividierer umfasst, um eine Verhältniszahl aus einem Eingangssample und einem entsprechenden gefilterten Ausgangssample zu bestimmen.

**3.** Filter nach Anspruch 1 oder 2, worin der Phasenrotationsschätzer (308) außerdem einen Begrenzer umfasst, um einen Bereich einer geschätzten Phasenrotation zu begrenzen.

**4.** Filter nach einem vorhergehenden Anspruch, das außerdem ein Glättungsfilter umfasst, das an den phasenkompensierten Filterausgang gekoppelt ist, um einen geglätteten Ausgang bereitzustellen.

**5.** Interpolationsfilter, das ein Filter nach einem der Ansprüche 1 bis 4 zum Interpolieren zwischen Werten der Eingangssamples umfasst, wobei das Interpolationsfilter außerdem einen Phasenrotationsinterpolator umfasst, um zwischen zwei der Phasenrotationsschätzungen zu interpolieren und interpolierte Phasenrotationsschätzungen zum Kompensieren für Phasenrotationen der interpolierten Eingangssamplewerte bereitzustellen.

**6.** OFDM-Kanalschätzer einschließlich des Filters nach einem der Ansprüche 1 bis 5, wobei das Filter dazu konfiguriert ist, zwischen OFDM-Kanalschätzungen zu interpolieren.

**7.** OFDM-Kanalschätzer einschließlich einer Vielzahl von Filtern nach einem der Ansprüche 1 bis 4, wobei jedes der Filter für Interpolation im Zeitbereich von Inter-Kanal-Schätzungen für einen OFDM-Subcarrier konfiguriert ist.

**8.** OFDM-Kanalschätzer nach Anspruch 7, außerdem mindestens eine Phasenrotationsinterpolation umfassend, um zwischen Phasenrotationsschätzungen der zwei Filter für zwei der OFDM-Subcarriers zu interpolieren und einem Phasenkompensator eines Interpolationsfilters im Zeitbereich für einen dritten Subcarrier eine interpolierte Phasenrotationsschätzung bereitzustellen.

**9.** Verfahren zur Interpolation im Zeitbereich in einem OFDM-Kanalschätzer unter Verwendung eines OFDM-Signals mit einer Vielzahl von Subcarriers, wobei die Subcarriers eine Struktur von Pilotsignalen unterstützen, worin mindestens erste und zweite Subcarriers ein Pilotsignal zu entsprechenden ersten Zeiten tragen, und worin ein dritter Subcarrier ein Pilotsignal zu zweiten Zeiten trägt, die von der ersten Zeit verschieden sind, wobei das Verfahren Folgendes umfasst:

Interpolieren zwischen den ersten Zeiten für die ersten und zweiten Subcarriers durch Filterung;
Bestimmen jeweiliger erster und zweiter geschätzter Phasenrotationen für die erste und zweite Subcarrier-Interpolation;
Kompensieren der Interpolation für die ersten und zweiten Subcarrier unter Verwendung der ersten und zweiten geschätzten Phasenzotationen;
Interpolieren zwischen den zweiten Zeiten für den dritten Subcarrier durch Filterung; und
Kompensieren für eine Phasenrotation der Filterung des dritten Subcarriers unter Verwendung einer geschätzten Phasenrotation, die von einer oder beiden ersten und zweiten geschätzten Phasenrotationen abgeleitet ist.

**Revendications**

**1.** Filtre numérique (300), le filtre comprenant :

une entrée pour recevoir des échantillons d'entrée de valeurs complexes ;
un suréchantillonneur (302) couplé à ladite entrée pour fournir une sortie suréchantillonnée comprenant un plus grand nombre desdits échantillons d'entrée ;
un filtre récursif (IIR) (304) couplé audit suréchantillonneur pour filtrer ladite sortie suréchantillonnée et fournir une sortie filtrée ;
un estimateur de rotation de phase (308) couplé à ladite entrée et à ladite sortie filtrée pour estimer une rotation de phase d'un dit échantillon d'entrée par ledit filtre ; et
un compensateur de phase (312) couplé à ladite sortie filtrée et audit estimateur de rotation de phase pour compenser ladite sortie filtrée quant à ladite rotation de phase estimée par ledit filtre IIR et pour fournir une sortie de filtre à phase compensée.

**2.** Filtre selon la revendication 1, dans lequel ledit estimateur de rotation de phase (308) comprend un diviseur pour déterminer un rapport entre un dit échantillon d'entrée et un échantillon de sortie filtré correspondant.

**3.** Filtre selon la revendication 1 ou 2, dans lequel ledit estimateur de rotation de phase (308) comprend en outre un limiteur pour limiter une plage d'une dite rotation de phase estimée.

**4.** Filtre selon l'une quelconque des revendications précédentes, comprenant en outre un filtre de lissage couplé à ladite sortie de filtre à phase compensée pour fournir une sortie lissée.

**5.** Filtre d'interpolation comprenant un filtre selon l'une quelconque des revendications 1 à 4 pour effectuer une interpolation entre les valeurs desdits échantillons d'entrée, le filtre d'interpolation comprenant en outre un interpolateur de rotation de phase pour effectuer une interpolation entre deux desdites estimations de rotation de phase et pour fournir des estimations de rotation de phase interpolées pour compenser les rotations de phase desdites valeurs d'échantillon d'entrée interpolées.

**6.** Estimateur de canal OFDM comprenant le filtre selon l'une quelconque des revendications 1 à 5, ledit filtre étant configuré pour effectuer une interpolation entre les estimations de canal OFDM.

**7.** Estimateur de canal OFDM comprenant une pluralité de filtres selon l'une quelconque des revendications 1 à 4, chaque dit filtre étant configure pour effectuer une interpolation dans le domaine temporel entre les estimations de canal pour une sous-porteuse OFDM.

**8.** Estimateur de canal OFDM selon la revendication 7, comprenant en outre au moins une interpolation de rotation de phase pour effectuer une interpolation entre les estimations de rotation de phase des deux dits filtres pour deux desdites sous-porteuses OFDM et fournir une estimation de rotation de phase interpolée a un compensateur de phase d'un filtre d'interpolation dans le domaine temporel pour une troisième dite sous-porteuse OFDM.

**9.** Procédé d'interpolation dans le domaine temporel dans un estimateur de canal OFDM utilisant un signal OFDM ayant une pluralité de sous-porteuses, lesdites sous-porteuses portant une structure de Signaux pilotes dans laquelle au moins des première et deuxième sous-porteuses transportent un signal pilote à des premiers instants correspondants, et dans laquelle une troisième sous-porteuse transporte un signal pilote à des deuxièmes instants différents desdits premiers instants, le procédé consistant à :

effectuer une interpolation entre lesdits premiers instants pour lesdites première et deuxième sous-porteuses par filtrage ;

**EP 1 821 407 B1**

déterminer des première et deuxième rotations de phase estimées respectives pour lesdites première et deuxième interpolations de sous-porteuses ;

compenser ladite interpolation pour lesdites première et deuxième sous-porteuses en utilisant lesdites première et deuxième rotations de phase estimées ;

effectuer une interpolation entre lesdits deuxièmes instants pour ladite troisième sous-porteuse par filtrage ; et

compenser une rotation de phase de filtrage de ladite troisième sous-porteuse en utilisant une rotation de phase estimée déduite de l'une desdites première et deuxième rotations de phase estimées ou des deux.

Figure 1a

Figure 1b

OFDM CARRIER INDEX

Time

OFDM SYMBOL NUMBER

EP 1 821 407 B1

Figure 1c

Figure 2

13

Zero-stuff or
sample and hold

X(k)

Interpolation

Y(k)

Phase Correction

302

304

IIR

314

z^{-LD}

312

305

308

306

z^{-FD}

÷

310

Interpolate rotator
values

300

## Figure 3

Interpolate Channel Estimate

H(k)

302

304

IIR

314

414

FIR

305

308

416

306

z^{-FD}

÷

402

412

Interpolate Rotator
correction

Rotator Correction
estimates for Carriers
k+1 to k+11

Interpolate Channel Estimate

H(k+12)

302

304

IIR

314

414

FIR

305

308

416

306

z^{-FD}

÷

410

400

## Figure 4a

CHANNEL
ESTIMATE — k + 0 → IIR INTERPOLATION FILTER
INPUT

PHASE
CORRECTION
ESTIMATE

TIME
INTERPOLATED
OUTPUT

402 ⟋

PHASE
CORRECTION
INPUT

CHANNEL
ESTIMATE — k + 3 → IIR INTERPOLATION FILTER
INPUT

TIME
INTERPOLATED
OUTPUT

404 ⟋

PHASE
CORRECTION
INPUT

CHANNEL
ESTIMATE — k + 6 → IIR INTERPOLATION FILTER
INPUT

TIME
INTERPOLATED
OUTPUT

406 ⟋

PHASE
CORRECTION
INPUT

CHANNEL
ESTIMATE — k + 9 → IIR INTERPOLATION FILTER
INPUT

TIME
INTERPOLATED
OUTPUT

408 ⟋

PHASE
CORRECTION
INPUT

CHANNEL
ESTIMATE — k + 12 → IIR INTERPOLATION FILTER
INPUT

TIME
INTERPOLATED
OUTPUT

410 ⟋

PHASE
CORRECTION
INPUT

412

PHASE
INTERPOLATOR

PHASE
CORRECTION
ESTIMATES

INTERPOLATED
PHASE
CORRECTION
VALUES TO IIR
INTERPOLATION
FILTERS

400 ⟋

# Figure 4b

15

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 03065609 A
- JP 2004104744 A
- WO 9960940 A